# EUROPEAN PATENT SPECIFICATION

(11) **EP 3 264 869 B1**
(45) Date of publication and mention of the grant of the patent: **07.06.2023**
(21) Application number: 17178847.4
(22) Date of filing: 29.06.2017
(51) Int. Cl.: H05K 1/02, H01L 23/544, H05K 1/03, H01L 23/373

(54) **SUBSTRATE WITH IDENTIFICATION PATTERN FOR SEPARATE ELECTRONIC CIRCUITS AND METHOD FOR PRODUCING THEREOF**
SUBSTRAT MIT IDENTIFIKATIONSMUSTER FÜR SEPARATE ELEKTRONISCHE SCHALTUNGEN UND VERFAHREN ZUR HERSTELLUNG DAVON
SUBSTRAT AYANT UN MOTIF D'IDENTIFICATION POUR CIRCUITS ÉLECTRONIQUES SÉPARÉS ET PROCÉDÉ DE PRODUCTION ASSOCIÉ

(30) Priority: 29.06.2016 BE 201605505
(43) Date of publication of application: 03.01.2018
(73) Proprietor: C-MAC Electromag bvba, 9600 Ronse (BE)
(72) Inventor: DEGRAEVE, Wim, 9690 Kluisbergen (BE)
(74) Representative: Brantsandpatents bv

(56) References cited:
- FR-A1- 2 859 870
- JP-B2- 3 192 911
- US-A- 4 947 335
- US-A1- 2006 223 228
- US-A1- 2008 164 588
- US-A1- 2014 217 581

## Description

### TECHNICAL DOMAIN

The invention relates to a substrate with a ceramic support layer comprising at least two separate electronic circuits that can be identified in a simple way and that can be traced to earlier production processes.

Additionally, a method is described for applying the identification patterns, and thus producing the circuits and substrates.

### STATE OF THE ART

In the mass production of electronic circuits, especially in case of highly performing components, it is of crucial importance that a producer can trace back the production process for a specific circuit as precise as possible. This is for example the case with production error, in which case the producer is possibly obliged to, but surely also important to avoid future errors, to know where the problems occurred at the production (which units handled the faulty circuit, which material had been used - batch, supplier and similar, which operator, ...). In this way, based thereupon, also other circuits can be checked where possible errors are present. Consumers and producers also ever more require such a 'traceability', especially if it is about high-end products for which a minimum percentage defective is allowed. Moreover, by providing this increased quality control, an especially low percentage defective can be provided to consumers, which is very important in particular markets, especially in the tender procedure, and especially risks for end consumers are strongly reduced. Typically, electronic circuits are produced (and also sold) in so-called panels, with thereupon a number (whether or not identical) circuits, that can be singulated in a following production process. Hereby, it should be remarked that, by making the circuits separately identifiable, it is possible to store a large amount of information about the production processes at the production of the circuit, that, in case of failure, can provide interesting information to avoid or reduce such problems in the future. As said, this information can amongst other things relate to choices of material, environmental parameters, production parameters and others. The present solutions of these problems are typically insufficient or impractical, and will moreover also often be time-consuming at the production and possible entail extra costs. The electronic circuits of an identification component (for example RFID tag) can for example be provided for, by means of which the characteristics of the electronic circuit can be retrieved. However, this is an extra component, which increases the price and moreover also takes space at the circuit, which is undesired considering the ever-increasing miniaturization. Moreover, they can also become damaged (particularly in case of damage to the circuit itself) and can in this way also not deliver any relevant information any more. For this reason and others, the applicant has looked for more efficient and simple ways to make electronic circuits identifiable.

JP 3192911 B2 discloses an electronic circuit with stress-reducing dimples. US 4947335 A discloses the provision of holes in the substrate layer of an electronic circuit, which holes are used as a binary identification pattern. US 2008/164588 A1 discloses an electronic circuit with a flat ceramic support layer, a metal layer and stress-reducing dimples. US 2006/223228 A1 discloses identification marks on a substrate with a ceramic support layer comprising at least two separate electronic circuits.

The present invention aims to find a solution for at least some of the above-mentioned problems. The invention aims to solve the problems by making use in an inventive way of tensile stress-reducing indentations on the circuit and by applying these per circuit in a pattern by means of which the circuit can be identified.

### SUMMARY OF THE INVENTION

In a first aspect, the invention relates to a substrate, preferably for use in power electronics, comprising:
a. a substantially flat, ceramic support layer comprising at least two separate electronic circuits that are connected along a weakened break line;
b. a metal layer on the separate electronic circuits at at least one side, preferably at both sides, of the ceramic support layer, in which the metal layer of the separate electronic circuits are separated along the break lines;

in which one metal layer of at least one, preferably each, of the electronic circuits of the substrate is provided with one or more dimples in the metal layer along at least one edge of the metal layer, in which the dimples are adapted for at least partially reducing tensile forces in the metal layer;
wherein the one or more dimples per electronic circuit form an identification pattern, in which the identification pattern distinguishes the electronic circuit in a unique way from at least the other electronic circuits of the substrate.

In a following aspect, the invention relates to a method for applying tensile force-reducing identification patterns on a metal layer of a substrate, in which the substrate comprises a multitude of electronic circuits, comprising the following steps:
a. providing the substrate, in which the electronic circuits comprise a metal layer at at least one side of a ceramic flat support layer;
b. applying one or more dimples in the metal layer along at least one edge of the metal layer, in which the dimples are adapted for at least partially reducing tensile forces in the metal layer;
   wherein the one or more dimples are applied in an identification pattern;
c. coupling the electronic circuits to the applied identification pattern in a central server.

Herein, the identification pattern distinguishes the electronic circuit in a unique way from at least the other electronic circuits of the substrate.

In a following aspect, the invention relates to a method for the improved production of substrates with a multitude of electronic circuits, in which the circuits comprise a metal layer at at least one side of a ceramic flat support layer:
a. producing the substrate along a production line with one or more production devices, in which the substrate is produced with one or more raw materials from identifiable batches of the one or more raw materials;
b. applying a tension-reducing identification pattern on a metal layer of the substrate according to the method described above;
c. centrally storing information relating to the production line and/or the production devices and/or the identifiable batch of the raw materials, that are used in the step of producing the substrate.

### DESCRIPTION OF THE FIGURES

**Fig. 1** shows a possible front side of a substrate with a multitude of electronic circuits.
**Fig. 2** shows a possible front side of an electronic circuit with tension reducing dimples in the metal layer.
**Fig. 3** shows a possible rear side of a substrate with a multitude of electronic circuits, provided with identification patterns.
**Fig. 4** shows an enlarged rear side of the substrate of Fig. 3 with a multitude of electronic circuits, provided with identification patterns.
**Fig. 5** shows a possible front side of an electronic circuit with tension reducing dimples in the metal layer.
**Fig. 6** shows a possible embodiment of an identification pattern at the rear side of an electronic circuit.
**Fig. 7****,** **8****,** **9** show further possible embodiments for identification patterns at the rear side of an electronic circuit.

### DETAILED DESCRIPTION

In a first aspect, the invention relates to a substrate, preferably for use in power electronics, comprising:
a. a substantially flat, ceramic support layer comprising at least two separate electronic circuits that are connected along a weakened break line;
b. a metal layer on the separate electronic circuits at at least one side, preferably at both sides, of the ceramic support layer, in which the metal layer of the separate electronic circuits are separated along the break lines;

in which one metal layer of at least one, preferably each, of the electronic circuits of the substrate is provided with one or more dimples in the metal layer along at least one edge of the metal layer, in which the dimples are adapted for at least partially reducing tensile stresses in the metal layer; and in which the one or more dimples per electronic circuit form an identification pattern, in which the identification pattern distinguishes the electronic circuit in a unique way from at least the other electronic circuits of the substrate. Similar extensions as for the separate circuits will hereby be possible for the whole substrate and should be considered as implicitly being part of the text.

Unless otherwise specified, all terms used in the description of the invention, including technical and scientific terms, shall have the meaning as they are generally understood by the worker in the technical field of the invention. For a better understanding of the description of the invention, the following terms are explained specifically.

"A", "an" and "the" refer in the document to both the singular and the plural form unless clearly understood differently in the context. "A segment" means for example one or more than one segment.

When "approximately" or "about" are used in the document together with a measurable quantity, a parameter, a period or moment, etc., variations of +/-20% or less, preferably +/-10% or less, more preferably +/-5% or less, still more preferably +/-1% or less, and even still more preferably +/-0.1% or less than and of the cited value are meant, as far as such variations apply to the invention that is described. It will however be clearly understood that the value of the quantity at which the term "approximately" or "about" is used, is itself specified.

The terms "include", "including", "consist", "consisting", "provide with", "contain", "containing", "comprise", "comprising" are synonyms and are inclusive of open terms that indicate the presence of what follows, and that do not exclude or prevent the presence of other components, characteristics, elements, members, steps, known from or described in the state of the art.

The term "practically unique identifier" refers to an identifier for a product that in practice is made uniquely for a particular edition or a number of equal products. Because the term "unique" is too final, and can never be fully guaranteed, it is supplemented with "practically" to indicate the context. Thus, in practice, for the production of a particular electronic circuit, a practically unique identifier can for example comprise at least 20 bits (dependent on the edition). As shown further in this document, it is easy to generate millions or even billions of separate identifiers without much influence on other aspects of the circuit.

The term "retraceable" and "retraceability" refer to the possibility to retrace a history of a product. This history can have a variable extent depending on the product, and can for example comprise: time of production/production steps, identification of raw materials (supplier, batch, characteristics, ...), devices used in the production, possible subcomponents of apparatus used at the production that specifically work on the product, error control data about product and/or groups of products, but is not limited thereto. On the contrary, all possible information that can be registered and used for later analysis of the production process in all its aspects, is appropriate thereto and is desirable.

The citation of numeric intervals by means of end points includes all integers, fractions and/or real numbers between the end points, including these end points.

Dimples (holes, dimples, indentations, ...) are in some cases made in metal layers of electronic circuits to reduce tensile stress, resulting from the manipulation of two materials with strongly different thermal expansion coefficients (ceramic support layer and metal layer) at the production. The metal layer is applied at high temperature, solidifies and subsequently further shrinks when cooling down, providing tensile stresses with the substantially invariable ceramic support layer onto which the metal layer is applied. To compensate this, dimples have been made. These tensile stress can lead to delamination (and loosing of the metal layer from the ceramic support layer), and thus to critical failure of the electronic circuit. The dimples appear as a succession of holes in the metal layer along the edge of the metal layer, considering the tensile stress can be high at this location. The dimples are moreover often applied to each metal layer of the substrate (for two-sided substrates coated with metal material, but also when at one side of the substrate, several separate surfaces are in metal), considering the tensile stress can be high there each time. For more information about some physical characteristics (dimensions, shape, location and similar) of these dimples, we also refer to amongst other things US 8,350,369, US 6,638,592, EP 1,061,783 or JP3,192,911. The applicant suggest to make use in a practical way of said advantages which these dimples offer, and that can also certainly be necessary in high-quality circuits, and to make the dimples in a particular identification pattern at at least one side of the circuit. Considering that at one side, the components are often placed and it will not always be possible to form all possible desirable identification patterns with the dimples, it is in the case of two-sided circuits coated with copper even more interesting, as the 'rear side' of the circuit, with the copper side that is not provided with components, is extremely appropriate for making the dimples in a pattern. As in the industry, these dimples can be made along the edges of the metal layer, but they can also have other shapes or take other places (more centrally, double lines, threefold or more, ...).

The metal layer (or layers) is typically formed by a metallisation that is bonded to the ceramic support layer via a heating process. At this heating process, the metal layer will settle at an increased temperature. After cooling-down, the metal will shrink (for copper, the linear thermal expansion coefficient at 20°C is about 17·10⁻⁶ per Kelvin). The ceramic support layer will be less subject to expansions and/or shrinking as the metal is heated in the binding process (copper is hereby typically heated to temperatures higher than 1000°C). Moreover, typical materials of which the substrate is made (e.g. silica or alumina oxide) are much less sensitive to expansion and shrinking through temperature modifications (for silica, the thermal expansion coefficient at 20°C is about only 2.6·10⁻⁶ per Kelvin, for alumina oxide about 8.1·10⁻⁶ per Kelvin, also for other types of wafer/support, this coefficient is significantly lower than that of the metal layer). Thus, in case of significant cooling-down, a substantial difference in length can occur at the different layers that are bonded to each other. Thus, the cooling-down produces tensile stresses as a result of the different shrinkings of the layers composing the circuit. These stress can warp the substrate and weaken it so that cracks occur (more easily), before, during or after use of the circuit. In order to limit such losses (these losses also already occur in successive production processes), the dimples were proposed and introduced. Moreover, cracks often occur when singulating the circuits from the circuit, as a result of which this occurs (almost) at the end of the production process, which leads to a significant reduction in productivity and material losses.

By reducing the amount of metal at particular places, the metal will, during and after the cooling-down, cause less stress at the underlying ceramic support layer, which increases the lifetime of the circuit. These reductions in metal are applied as so-called 'dimples', a pattern of holes along the edges of the metal layer (with a diameter of about 0.5 mm, although variations thereto are certainly possible; the same goes for the depth of the dimples, also because they also depend on the thickness of the metal layer), as well as the shape. Moreover, in case several rows of dimples occur along one and the same edge, one can also opt for differences in diameter and/or depth and/or spacing between the dimples. The rows of dimples closer to the edge of the metal layer preferably have a larger diameter than those further from the edge. In this context, we refer again to the above-mentioned patent documents, in which one single or several series of `dimples' are present along the edges of the metal layer of the circuit (see also the figures of document US 8,350,369 B2) for reducing the tensile stresses between the layers of the circuit. The advantages thereof are discusses in detail in amongst other things US 6,638,592 B1.

The applicant noticed that in certain markets of electronic products, it is very important that there is a (preferably simple, cheap) traceability for products, especially in case of problems such as sudden cracks. By providing this traceability of (whether or not) defective products, all products of the panel or substrate to which the defective product belonged, and/or that were treated by the same installation, and/or that were produced from one and the same batch of material, ... can for example also be detected and for example called-back to avoid future problems, as well as to carry out further analysis to avoid, reduce and/or trace/predict the problem in the future. In this way, production processes can be optimized, defective (or anomalous) production devices/systems can be detected quickly. These steps allow to produce at lower cost, as to both the material used and the working hours. Moreover, a consumer can be offered a larger certainty (or lower error margin), which is amongst other things taken into account at larger tenders.

By giving the dimples for the stress reduction a second function, namely as an identifier, the limited space for electronic circuits is used ingeniously, moreover in a very cheap way. As is shown in the figures of said prior art documents, practically a large number of such dimples is present on the circuits. Hereby, a binary pattern can be simply placed (whether or not presence of a dimple at a number of places, or along a whole edge, ...) without compromising the effectiveness of the dimples, the reduction of tensile stresses. Indeed, even in case of a reduced number of dimples, for example 100 along the whole edge, the non-occupancy of 2 'positions' (no dimple) can very simply offer 4,950 unique identifiers, the non-occupancy of 3 positions, even 161,700. By working for example with double rows of dimples, there are 196 possible positions then, and with 2 free places, already 19,110 identifiers can be provided, and with 3 open positions more than 1 million. All of this without significant influence on the original function of the dimples. Moreover, as a compensation, additional dimples can be provided so that the intended effect of reduction of the tensile stresses is sufficiently realized. Moreover, along only one edge of the metal layer, dimples can be provided, or symmetrically at opposing edges.

In general, one can choose to identify an electronic circuit in different ways with the identifiers. This can be done in a unique way per substrate to which the circuit belongs, but also in a unique way as a circuit as such (considering the large amount of unique identifiers that can be produced by for example leaving 6 out of 100 positions free: 1,192,052,400; or leaving 10 out of 100 positions free: 17,310,309,456,440). Both cases will be each further discussed later in this document.

A further advantage of this identification is that during the production process, each circuit can also be 'recognized' relatively easily by the machines working onto it. The identification patterns are preferably easy to 'read' by the machines. In this way, for each circuit, information can be registered in a correct way, by associating it with the identification pattern (and a possible other identifier). This information can deal about information (supplier, batch number, ...) of raw materials or subcomponents, the operator, the specific machine or part of the machine and other.

Moreover, it should be noted that the identification patterns can not only be read or recognised visually, but also in a non-visual way. This offers amongst other things advantages if the circuits are mounted, soldered or glued in a casing or attached in any other way, or even completely covered. By for example making use of X-ray or Scanning Acoustic Microscopy (SAM), the identification patterns can still be visualised and thus the circuits can be 'recognized'. This allows to read the identification pattern in a nondestructive way, which amongst other things can be useful for later problems, considering the circuits can then typically already be part of a larger assembly or device. Known systems or methods for identifying circuits sometimes provide a label, such as a bar code or QR code on the circuits, that are not visible any more or difficult to read once the circuit has been installed.

In a preferred embodiment, the identification pattern of the electronic circuit forms a practically unique identifier for the electronic circuit and in which this practically unique identifier can distinguish the electronic circuit practically in a unique way from at least 2⁵, or rather 2¹⁰, and preferably 2¹⁵, more preferably 2²⁰, still more preferably at least 2²⁵ and even still more preferably 2³⁰, other electronic circuits with their own identification patterns as practically unique identifier. In theory, a less unique identification pattern can be chosen than in the preferred situations described below, in which the circuits then only have to be identified per substrate (panel in which the circuits start, and sometimes also end, the production). Typically, the substrate will then also comprise a separate identifier, for example a QR code, bar code and/or identification number.

In a preferred embodiment, the dimples are provided along edges of the metal layer, preferably over one line per edge of the metal layer in which the line per edge is parallel to the edges of the metal layer. Other options are that more lines or rows of dimples extend parallel to each other along the edge, as a result of which a larger number of identification patterns can be provided and a sufficient tensile stress-reducing effect can be guaranteed.

In a preferred embodiment, a multitude of identification positions are provided along the edges of the metal layer, and the identification pattern is defined by the occupancy and/or non-occupancy of the identification positions with a dimple, preferably in which the successive identification positions have a spacing between 200 µm and 2000 µm. 'Spacing' refers to the distance between the centres of successive dimples. As this is the positioning of tensile stress-reducing dimples used in practice, it is also logical and effective to keep the distances as recommended above. Therefore, preferences are also known that depend especially on the thickness of the copper layer (metal layer). Thus, for a copper layer with a thickness of about 300 µm, a spacing of about 800 µm, or between 700 and 900 µm, is typically used, in which the dimples have a diameter of about 600 µm, or between 500 and 700 µm, and preferably about 500 µm, or between 400 and 600 µm, for a dimple in a corner of a circuit. By moreover applying the identification pattern on a certain number of identifications positions, which amounts to being occupied or not by dimples of the identification positions, it is easy to read the identification patterns in an automated way, as it deals about a limited number of positions that are moreover preferably situated at fixed places on the circuit.

In the following, the term "identification positions" should somehow be defined for this document. Hereby, one assumes that in a 'normal' circuit with tensile stress-reducing dimples along the complete edge, each of the dimples indicates the location of an identification position. In a preferred embodiment, at least 25%, preferably at least 50%, of the identification positions is occupied by a dimple, more preferably in which at least 33% van the identification positions along each edge separately are separately occupied by an dimples, and in which the identification pattern has a binary representation as a result of the occupancy and/or non-occupancy of the identification positions with the dimples. Still more preferably, at least 60%, 65%, 70%, 75%, 80%, 85%, 90%, 95% or more of the identification positions is occupied by a dimple. Possible minimal occupancy percentages are for example 61%, 62%, 63%, 64%, 66%, 67%, 68%, 69%, 71%, 72%, 73%, 74%, 76%, 77%, 78%, 79%, 81%, 82%, 83%, 84%, 86%, 87%, 88%, 89%, 91%, 92%, 93%, 94%, 96%, 97%, 98%, 99%. The main effect thereof is that in this way, it is sufficiently guaranteed that the original effect of the dimples, the reduction of tensile stress, is realized sufficiently.

Note that it is possible to effectively use only a limited number of the above-said identification positions, in other words, in which the possible positions of the dimples only have to be read in a limited number of positions (for example a central band of N positions). In that case, one can of course make an exception to the above-said preferred embodiment as the definition of identification position differs in that case.

In a preferred embodiment, at least one of the identification positions along at least one edge is not occupied by a dimple. Note that one can also choose to carry out these non-occupied position at two (whether or not opposing) edges, or at 3 or 4 edges (or even more preferably at non-square circuits). Moreover, typically, at least 2 (or 3, 4 or more) of the identification positions will not be occupied along at least one edge in order to create a clearer identification pattern in this way.

Preferably, the at least one non-occupied identification position is situated between identification positions of the at least one edge occupied by dimples. Note that this does not necessarily mean that the adjacent identification positions are occupied. In other words, this means that the non-occupied identification position(s) most preferably are not situated at the ends of the edge, in order not to create any confusion, but that this will be 'internal' non-occupied positions. Generally, one can also say that maximum 90% of the identification positions along at least one edge can be occupied by a dimple. These remarks apply to both the circuit according to the invention separately, and a substrate comprising a multitude of circuits.

In a preferred embodiment, the metal layer at the level of the dimples has a volume reduction between 10% and 100%, preferably between 30% and 80%, with respect to the metal layer without dimples, preferably so that the dimples have a depth of at least 50 µm with respect to the surrounding plane of the metal layer. The dimples preferably not to completely extend to the ceramic support layer, as this can lead to delamination. Possible maximum depths of the dimples (however, depending on the thickness of the metal layer) are 100 µm, 150 µm, 200 µm, 250 µm, 300 µm, 400 µm, 500 µm or more. As to the diameter, one chooses for at least 300 µm and maximum 1500 µm, preferably depending on the thickness of the metal layer. Typically, a thickness of the copper layer (metal layer) of about 0,30 mm is chosen for a diameter of the dimples of about 600 µm, or between 500 and 700 µm, and preferably about 500 µm, or between 400 and 600 µm, for a dimple in a corner of a circuit.

In this way, not only the conditions are met to have the tensile stress-reducing effect on the circuit, but it is moreover also possible and easier to observe the identification patterns. The shape and dimensions of the dimples are such that they can realize the tensile stress-reducing effect on the circuit in an optimal way, as has been described above. The dimples can have the shape of a segment of a sphere, a paraboloid shape, a cylindrical cut of other. By not using a complete (100%) reduction as a measure, for example maximum 80%, the process of providing dimples is also much easier, and this is possible for example via a simple laser treatment (laser etching). Also, the zone between successive dimples can undergo a volume reduction with respect to the general metal layer around.

Possible values for the volume reduction are furthermore 20%, 25%, 35%, 40%, 45%, 47.5%, 50%, 52.5%, 55%, 57.5%, 60%, 65%, 70%, 75%, 85%, 90%, 95% or any value in between. As said, the dimensions of the dimples are also partially dependent on the dimensions of the circuit itself (thickness metal layer for example), and thus dimples with a thickness of 20 µm, 25 µm, 30 µm, 35 µm, 40 µm, 45 µm, 55µm, 60 µm, 65 µm, 70 µm, 75 µm, 80 µm, 85 µm, 90 µm or any other values (in between) are also possible. The same remark applies to the radius (width) of the dimple, that can vary, and can have values such as 75 µm, 80 µm, 85 µm, 90 µm, 95 µm, 100 µm, 105 µm, 110 µm, 120 µm, 130 µm, 140 µm, 150 µm, 160 µm, 170 µm, 180 µm, 190 µm, 200 µm, 225 µm, 250 µm, 275 µm, 300 µm, 325 µm, 350 µm, 375 µm, 400 µm, 425 µm, 450 µm, 475 µm, 500 µm, 550 µm, 600 µm, 650 µm, 700 µm, 750 µm, 800 µm, 850 µm, 900 µm, 950 µm, 1000 µm, or any other value (in between).

In a preferred embodiment, along at least one edge (1, 2, 3, 4 or more at non-square circuits) of the metal layer, two or more (3, 4, 5, 6, 7, 8, 9, 10, ...) parallel rows of dimples are provided for forming the identification pattern. As said above, this offers the certainty that the tensile stress-reducing effect of the dimples is achieved, and this offers moreover more possibilities for applying an identification pattern. One the one hand, this offers more possibilities for unique identification patterns, but on the other hand, this also offers the possibility for applying clearer (easier to read) patterns, because larger 'structures' can be brought into the pattern, without reducing the effect of the dimples.

As is the case for the separate electronic circuits discussed earlier, here too, the principle of the traceability of the separate electronic circuit is very important, both during the production process and after sale or transport. In this way, problems in the supply chain, in the raw materials and similar can be detected and solved optimally. The arguments described in this document relating to the advantages when using the inventive concept in electronic circuits, obviously also apply to the application thereof at a substrate of several circuits.

In this document, we will not further discuss the general characteristics of such substrates of electronic circuits, as they are largely known, and are considered as implicitly part of the patent application. Only the aspects that are relevant for understanding the said invention, will possible be further discussed in the text below. The possible embodiments of the substrates with electronic circuits are in no way limited to these shown in the figures, but can be considered as belonging to the know-how of an expert in the domain of (power) electronics.

As is shown in the figures, all electronic circuits of the substrate are provided with an identification pattern that identifies them at least in a unique way with respect to the other circuits of the substrate.

In a preferred embodiment, the substrate is provided with a substrate identification for identifying the substrate in a practically unique way, preferably a one-dimensional or two-dimensional bar code, such as a bar code or a QR code. This allows not to only have to provide the circuits with a unique identification pattern with respect to all other (similar) circuits, but only with respect to the circuits in the same substrate. In this way, much more simple and better readable identification patterns can be used for the separate circuits themselves, that indicate for example the relative position of the circuit in the substrate. The position of such a substrate identification can be realized in different ways, for example on so-called "waste borders" (see also in the figures).

Alternatively, the circuits can of course also be provided with a unique identification pattern making the substrate identification superfluous. In a preferred embodiment, the identification pattern of each electronic circuit forms a practically unique identifier for the electronic circuit and in which the practically unique identifier can distinguish the electronic circuit in a practically unique way from at least 2²⁰, preferably 2²⁵, more preferably 2³⁰, other electronic circuits with the identification patterns as practically unique identifier.

In a preferred embodiment, for each electronic circuit, the dimples are provided along edges of the metal layer, preferably over one line per edge of the metal layer in which the line per edge is parallel to the edges of the metal layer. Alternatively, more lines or rows of dimples are provided along one or more edges of the metal layer. These several lines or rows per edge can be positioned in a crossed way.

In a preferred embodiment, for each electronic circuit, a multitude of identification positions are provided along the edges of the metal layer, and in which the identification pattern is defined by the occupancy and/or non-occupancy of the identification positions by a dimple, preferably in which the successive identification positions have a spacing between 200 µm and 2000 µm. In this context, we refer to what has been described for the separate circuits.

In a preferred embodiment, for each electronic circuit, at least 25%, preferably at least 50%, of the identification positions is occupied by a dimple, more preferably in which at least 33% van the identification positions along each edge separately are occupied by an dimples, and in which the identification pattern has a binary representation as a result of the occupancy and/or non-occupancy of the identification positions with the dimples. Still more preferably, at least 70%, 75%, 80%, 85%, 90%, 95% or more of the identification positions is occupied by a dimple. Possible minimal occupancy percentages are for example 61%, 62%, 63%, 64%, 66%, 67%, 68%, 69%, 71%, 72%, 73%, 74%, 76%, 77%, 78%, 79%, 81%, 82%, 83%, 84%, 86%, 87%, 88%, 89%, 91%, 92%, 93%, 94%, 96%, 97%, 98%, 99%. The main effect thereof is that in this way, it is sufficiently guaranteed that the original effect of the dimples, the reduction of tensile stress, is realized sufficiently.

In a preferred embodiment, the substrate relates to a directly bonded copper (DBC) ceramic substrate. Such substrates are especially popular in power electronics because of their especially good characteristics in the domain of thermal conductivity. However, despite the good values, temperature modifications occur quite often, which can again lead to (often smaller) tensile stresses. Because of the presence of dimples, they are however rarely problematic, but it makes such DBC substrates excellent candidates for the proposed invention, as the dimples are already present in most embodiments thereof, and it thus requires only a small adjustment to make the circuits identifiable.

In a preferred embodiment, the metal layer at the level of the dimples has a volume reduction between 10% and 100%, preferably between 30% and 80%, with respect to the metal layer without dimples, preferably so that the dimples have a depth of at least 50 µm with respect to the surrounding plane of the metal layer and have a radius of in average at least 100 µm. Possible values for the volume reduction are furthermore 20%, 25%, 35%, 40%, 45%, 47.5%, 50%, 52.5%, 55%, 57.5%, 60%, 65%, 70%, 75%, 85%, 90%, 95% or any value in between. As said, the dimensions of the dimples are also partially dependent on the dimensions of the circuit itself (thickness metal layer for example), and thus dimples with a thickness of 20 µm, 25 µm, 30 µm, 35 µm, 40 µm, 45 µm, 55µm, 60 µm, 65 µm, 70 µm, 75 µm, 80 µm, 85 µm, 90 µm or any other values (in between) are also possible. The same remark applies to the radius (width) of the dimple, that can vary, and can have values such as 75 µm, 80 µm, 85 µm, 90 µm, 95 µm, 100 µm, 105 µm, 110 µm, 120 µm, 130 µm, 140 µm, 150 µm, 160 µm, 170 µm, 180 µm, 190 µm, 200 µm, 225 µm, 250 µm, 275 µm, 300 µm, 325 µm, 350 µm, 375 µm, 400 µm, 425 µm, 450 µm, 475 µm, 500 µm, 550 µm, 600 µm, 650 µm, 700 µm, 750 µm, 800 µm, 850 µm, 900 µm, 950 µm, 1000 µm, or any other value (in between). The advantages thereof have already been discussed for the separate circuits, and thus also apply in general to the substrate.

In a second aspect, the invention relates to a method for applying tensile force-reducing identification patterns on a metal layer of a substrate, in which the substrate comprises a multitude of electronic circuits, comprising the following steps:
a. providing the substrate, in which the electronic circuits comprise a metal layer at at least one side of a ceramic flat support layer;
b. applying one or more dimples in the metal layer along at least one edge of the metal layer, in which the dimples are adapted for at least partially reducing tensile forces in the metal layer;
   in which one or more dimples are applied in an identification pattern, in which the identification pattern distinguishes the electronic circuit at least in a unique way from the other electronic circuits of the substrate;
c. and coupling the electronic circuits to the applied identification pattern in a central server.

Hereby, all possible adjustments to the identification pattern as described in the present document can be applied to the method as described above. The advantages that have already been discussed in the embodiments and products themselves, logically also apply to the method. By applying the identification pattern as suggested, an identification component is avoided (cheaper) and the action of making the circuits/substrates identifiable must not be carried out separately any more, and this is simply part of a step that normally already is part of the production process.

In a third aspect, the invention relates to a method for the improved production of substrates with a multitude of electronic circuits, in which the circuits comprise a metal layer at at least one side of a ceramic flat support layer:
a. producing the substrate along a production line with one or more production devices, in which the substrate is produced with one or more raw materials from identifiable batches of the one or more raw materials;
b. applying a tension-reducing identification pattern on a metal layer of the substrate according to the above-described method;
c. centrally storing information relating to the production line and/or the production devices and/or the identifiable batch of the raw materials, that are used in the step of producing the substrate.

Hereby, all possible adjustments to the identification pattern as described in the present document can be applied to the method as described above. By applying an identification pattern as described in the present document, it is, as said, possible to carry out an intensive error analysis and to optimize the production process.

In a fourth aspect, the invention relates to a use of one or more dimples as identification pattern for an electronic circuit according to claim 7.

In the following, the invention will be described by means of non-limiting examples illustrating the invention, and not meant to be interpreted as limiting the scope of the invention.

### EXAMPLES

The applicant wishes to notice that only a number of possible embodiments of the identification patterns is shown in the figures and discussed in the examples.

Further, one should notice that the identification patterns are preferably applied onto the metal layer at the rear side of the electronic circuit as the components at the front side can possibly make the application of a pattern impossible and/or can reduce the readability of the identification pattern. The applicant does however not reject the possibility that the front side (whether or not together with the rear side) of such identification pattern is provided. On the other hand, the front side can be provided with the dimples without an identification pattern being applied herein.

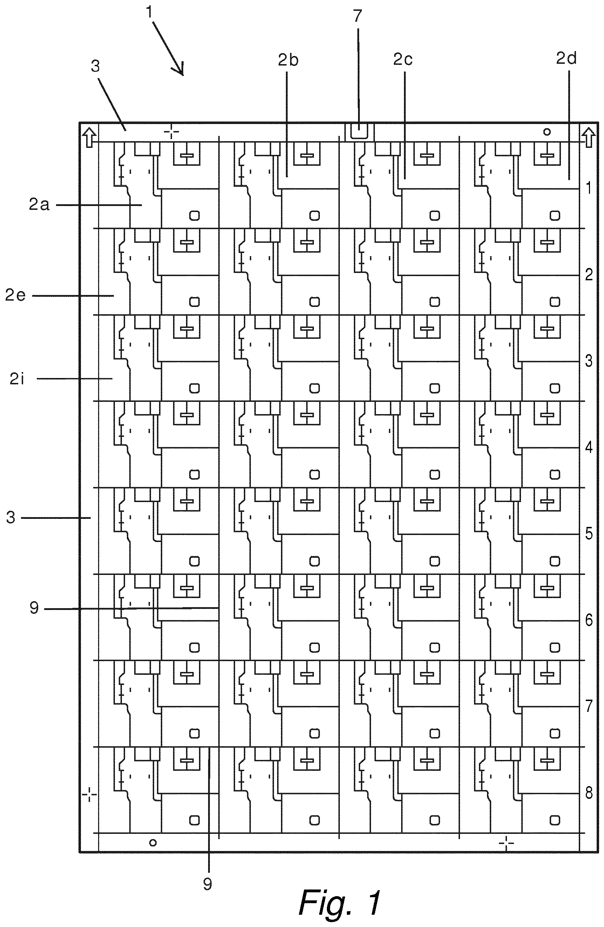

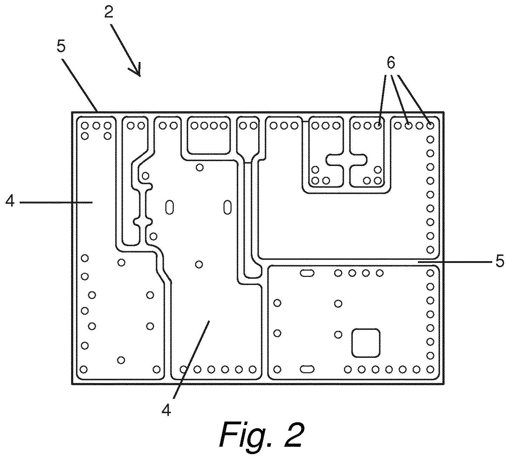

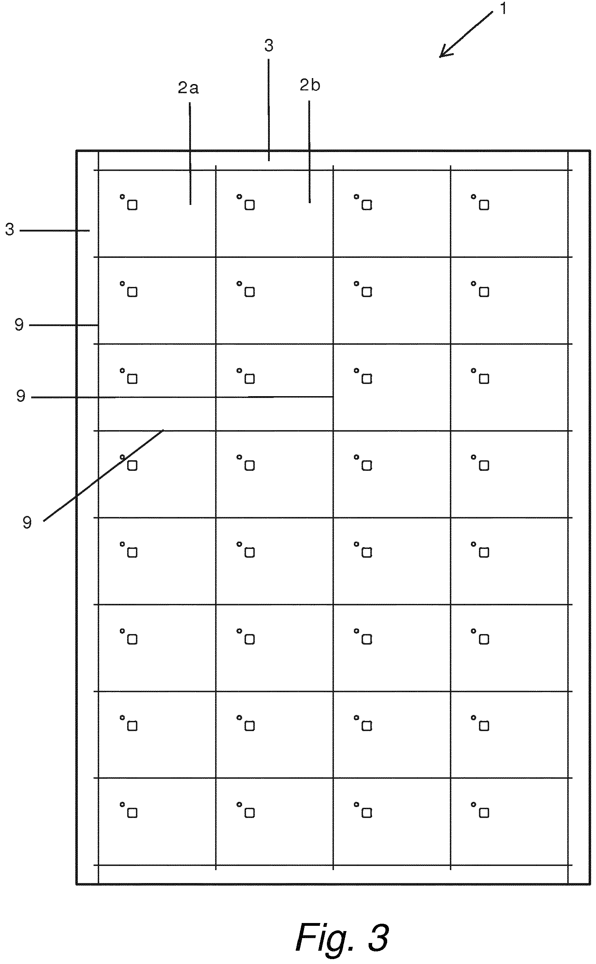

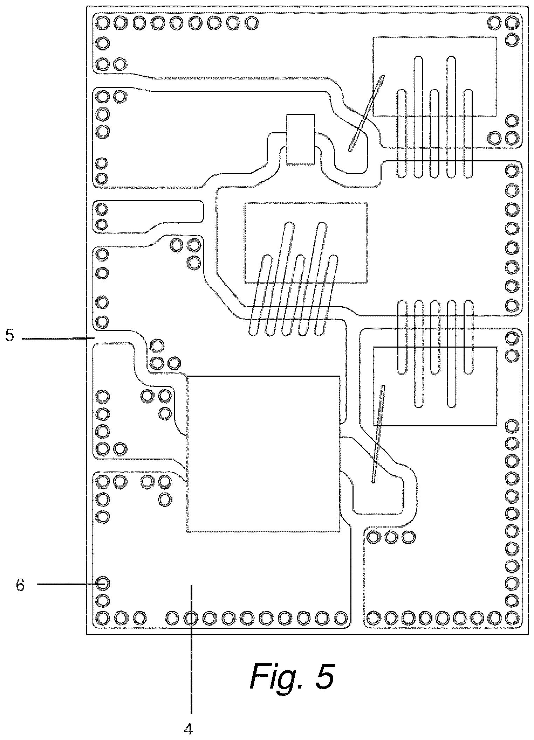

Fig. 1 shows a general view of the front side of a substrate (1) with electronic circuits (2a, 2b, 2c, ...), composed of a ceramic support layer (5) with thereupon a metal layer (4), whether or not at the front and rear side. The substrate (1) comprises in this case a grid of 4 out of 8 electronic circuits (2a, 2b, 2c, ...), that can be broken off from each other along predetermined break lines (9). This are weakened parts in the ceramic support layer (5) of the substrate between the separate circuits (2a, 2b, 2c, ...). Furthermore, a substrate (1) comprises mostly one or several breakable edges or 'waste borders' (3) that amongst other things serve to clamp and move the substrate (1) without causing damage to the circuits (2). Optionally, a substrate identification (7) can be applied to such a breakable edge (3). Fig. 2 shows a possible view of the front side of a separate electronic circuit (2) without components, Fig. 5 shows the same with additional components and connections. As is shown in these figures, the front side of the electronic circuit (2) composes of a ceramic support layer (5) with thereupon a number of islands of the metal layer (4). These islands of the metal layer (4) can be provided along the edges with dimples (6), for reducing the tensile stress. They also serve as an identification pattern (whether or not combined with an identification pattern at the rear side of the electronic circuit). Fig. 3 shows a general view of the rear side of a substrate (1) with electronic circuits (2a, 2b, ...). The breakable edges (3) and break lines (9) are hereby also clearly shown. Note that the break lines are not necessarily provided along both sides in the ceramic support layer.

### EXAMPLE 1:

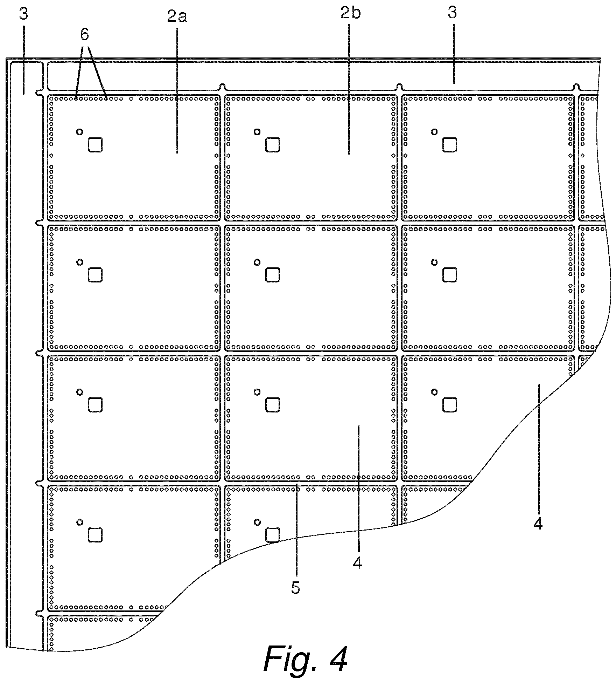

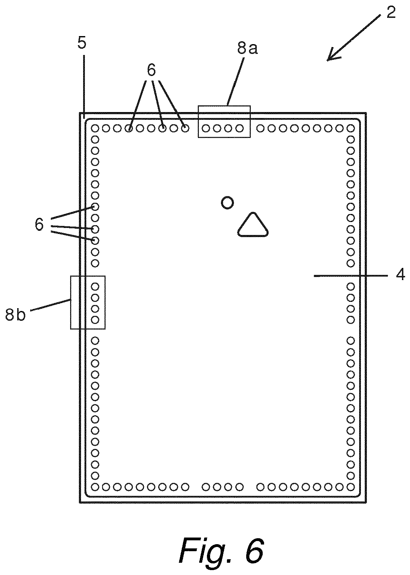

In a first example, a single row of dimples (6) is provided along the edges of the metal layer (4) of each circuit (2). In this variant, the substrate (1) has a substrate identification (7) in the form of a QR code. The identification pattern of the dimples (6) is thus provided for indicating the position of a circuit in a substrate (1). For reasons of simplicity, we have here opted for that the upper and lower series of dimples on a circuit has a central 'free' island (8a) with dimples that indicate in which column of the substrate the circuit is located. The left and right series of dimples of a circuit also has a central free island (8b) with dimples that indicate in which row of the substrate the circuit is located. In this example, it is indicated by the number of dimples of which the central free island is composed. This is clearly indicated in Fig. 6, in which the upper series 4 comprises dimples in the central island (8a), as well as the left series that comprises 4 dimples in the central island (8b), and indicates that the circuit (in this way of arranging the identification pattern) was in the fourth row and fourth column of the substrate for singulation. A general view thereof is shown in Fig. 4.

### EXAMPLE 2:

Alternatively, a succession of dimples can be read as a binary code (in which they occur at fixed intervals or not, a possible dimple can be read as a '1', an absence as a '0' and vice versa). The position of the first 'bit' or start bit can be fixed deliberately, or a more general convention can be laid down in this context, as well as a reading direction (clockwise or counter-clockwise). Again referring to Fig. 6, in which the start bit is placed in the upper left corner and is read in clockwise direction, the 108 bits of the binary code are: 111111111 0 1111 0 111111111 111111111111 0 1111 0 111111111111 111111111 0 1111 0 111111111 111111111111 0 1111 0 111111111111. In this way, also Fig. 4 can be completely interpreted again with respect to example 1. As said, subsequently minimal conditions can be laid down here, such as a minimal occupancy with dimples for the code. Even with a minimal occupancy of 92.5% (maximum 8 'holes' or unoccupied places), this offers the option for 352,025,629,371 unique codes. In this way, a substrate identification is no longer necessary, and the production process of specific circuits can still be found more easily.

### EXAMPLE 3:

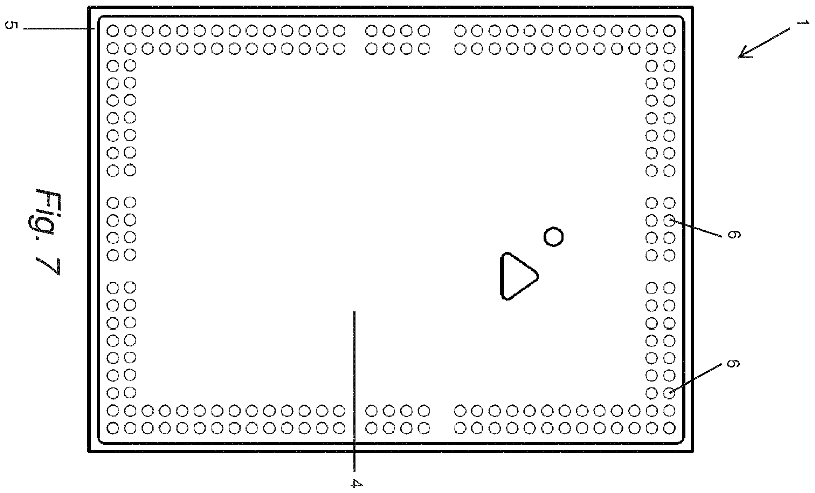

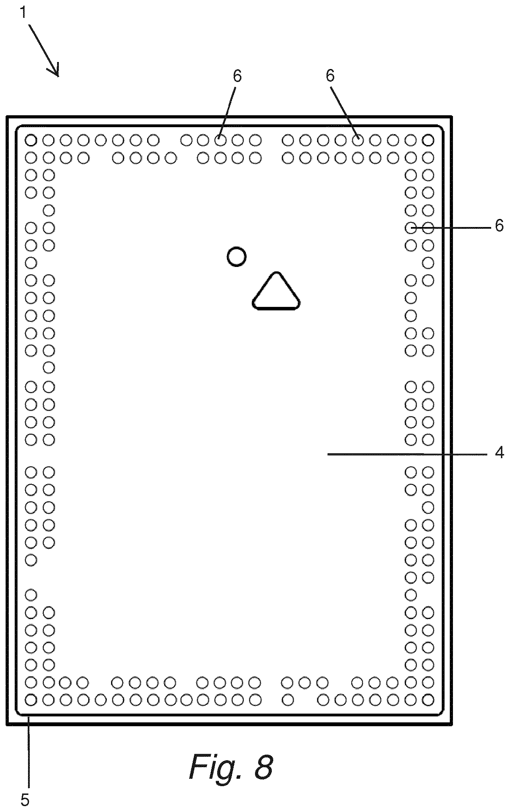

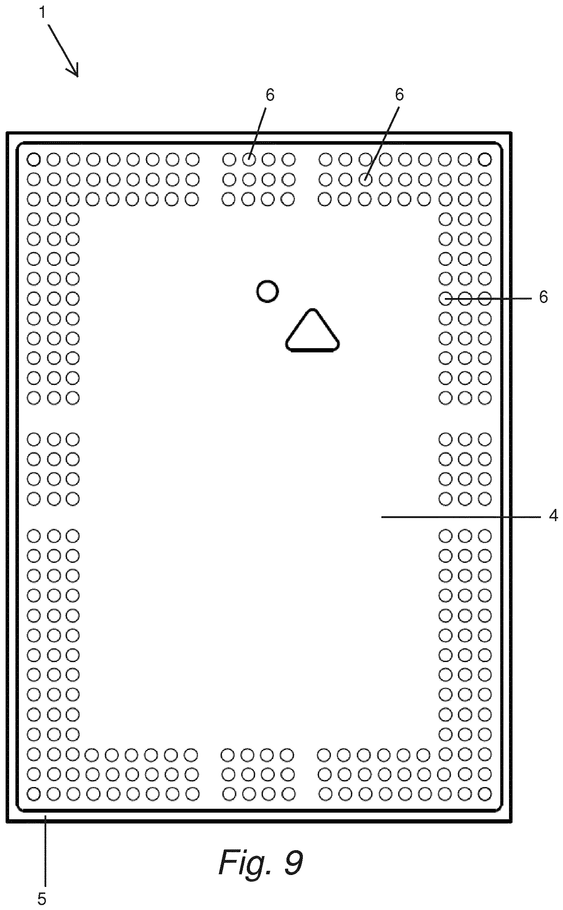

In this embodiment, shown in Fig. 7 or Fig. 8, a double row of dimples is provided. The double rows can indicate the same pattern, as in Fig. 7 (for increased readability) or different pattern, as in Fig. 8 (for more unique identification patterns). The way in which the identification patterns can be read (see examples 1 and 2) vary and are dependent on the choice of a user. Nevertheless, the applicant considers possible variations (triple rows as in Fig. 9, crossed double/triple rows, asymmetry, ...) on patterns also as part of this document, as it is based on the same basic idea.

It will be understood that the present invention is not limited to the embodiments described above and that some adjustments or changes can be added to the described examples without changing the scope of the enclosed claims. The present invention has for example been described with reference to electronic circuits for power electronics, specific so-called DBC substrates and circuits, but it will be clear that the invention can also be applied to all kinds of circuits comprising several layers between which tensile stress can occur at the production and in which identifiability of the concerned circuits is desired.

## Claims

1. Substrate (1), preferably for use in power electronics, comprising:
a. a substantially flat, ceramic support layer (5) comprising at least two separate electronic circuits (2a, 2b, 2c) that are connected along a weakened break line (9);
b. a metal layer (4) on the separate electronic circuits at at least one side, preferably at both sides, of the ceramic support layer, in which the metal layer of the separate electronic circuits are separated along the break lines;
in which one metal layer of at least one, preferably each, of the electronic circuits of the substrate is provided with one or more dimples (6) in the metal layer along at least one edge of the metal layer, in which the dimples are adapted for at least partially reducing tensile forces in the metal layer;
wherein the one or more dimples per electronic circuit form an identification pattern, in which the identification pattern distinguishes the electronic circuit from at least the other electronic circuits of the substrate.

2. Substrate of the previous claim 1, in which the substrate is provided with a substrate identification (7) for the practically unique identification of the substrate, preferably a one-dimensional or two-dimensional bar code.

3. Substrate of any one of the previous claims 1 or 2, in which the identification pattern of each electronic circuit forms a practically unique identifier for the electronic circuit and in which the practically unique identifier can distinguish the electronic circuit in a practically unique way from at least 2²⁰, preferably 2²⁵, more preferably 2³⁰, other electronic circuits with the identification patterns as practically unique identifier.

4. Substrate of any one of the claims 1 to 3, in which the dimples for each electronic circuit are provided along edges of the metal layer, preferably over one line per edge of the metal layer in which the line per edge is parallel to the edges of the metal layer.

5. Substrate of any one of the claims 1 to 4, in which, for each electronic circuit, a multitude of identification positions are provided along the edges of the metal layer, and in which the identification pattern is defined by the occupancy and/or non-occupancy of the identification positions by a dimple, preferably in which the successive identification positions have a spacing between 200 µm and 2000 µm.

6. Substrate of any one of the previous claims 1 to 5, in which at least one of the identification positions along at least one of the edges is not occupied by a dimple, preferably in which this at least one unoccupied identification position is situated between indication positions that are occupied by dimples of the at least one edge, and in which the identification pattern has a binary representation as a result of the occupancy and/or non-occupancy of the identification positions with the dimples.

7. Use of one or more dimples (6) as identification pattern for an electronic circuit (2a, 2b, 2c), in which the electronic circuit comprises a substantial flat, ceramic support layer (5), and a metal layer (4) at at least one side, preferably at both sides, of the ceramic support layer, in which at least one metal layer is provided with the dimples in the metal layer along at least one edge of the metal layer, and in which the dimples are adapted for at least partially reducing the tensile stresses in the metal layer; wherein the identification pattern distinguishes the electronic circuit from at least other electronic circuits comprising the same ceramic support layer (5), preferably in which the electronic circuit concerns a directly bonded copper (DBC) ceramic substrate circuit for use in power electronics.

8. Method for applying tensile stress-reducing identification patterns on a metal layer (4) of a substrate (1), in which the substrate comprises a multitude of electronic circuits (2a, 2b, 2c), comprising the following steps:
a. providing the substrate (1), in which the electronic circuits (2a, 2b, 2c) comprise a metal layer (4) at at least one side of a ceramic flat support layer (5);
b. applying one or more dimples (6) in the metal layer along at least one edge of the metal layer, in which the dimples are adapted for at least partially reducing tensile forces in the metal layer;
wherein one or more dimples are applied in an identification pattern, in which the identification pattern distinguishes the electronic circuit at least in a unique way from the other electronic circuits of the substrate;
c. coupling the electronic circuits to the applied identification pattern in a central server.

9. Method for the improved production of substrates with a multitude of electronic circuits (1), in which the circuits comprise a metal layer (4) at at least one side of a ceramic flat support layer (5):
a. producing the substrate (1) along a production line with one or more production devices, in which the substrate is produced with one or more raw materials from identifiable batches of the one or more raw materials;
b. applying a stress-reducing identification pattern on a metal layer of the substrate according to the method of the previous claim 8;
c. centrally storing information relating to the production line and/or the production devices and/or the identifiable batch of the raw materials, that are used in the step of producing the substrate.

## Patentansprüche

1. Substrat (1), vorzugsweise zur Verwendung in Leistungselektronik, Folgendes umfassend:
a. eine im Wesentlichen ebene keramische Trägerschicht (5), die mindestens zwei separate elektronische Schaltungen (2a, 2b, 2c) umfasst, die entlang einer geschwächten Bruchlinie (9) verbunden sind,
b. eine Metallschicht (4) auf den separaten elektronischen Schaltungen an mindestens einer Seite, vorzugsweise an beiden Seiten der keramischen Trägerschicht, wobei die Metallschicht der separaten elektronischen Schaltungen entlang der Bruchlinien getrennt ist,
wobei eine Metallschicht mindestens einer, vorzugsweise jeder der elektronischen Schaltungen des Substrats mit einer oder mehreren Vertiefungen (6) in der Metallschicht entlang mindestens eines Randes der Metallschicht versehen sind, wobei die Vertiefungen dafür eingerichtet sind, Zugkräfte in der Metallschicht zumindest teilweise zu mindern,
wobei die eine oder die mehreren Vertiefungen pro elektronischer Schaltung ein Kennzeichnungsmuster bilden, wobei das Kennzeichnungsmuster die elektronische Schaltung von mindestens den anderen elektronischen Schaltungen des Substrats unterscheidet.

2. Substrat nach dem vorhergehenden Anspruch 1, wobei das Substrat mit einer Substratkennzeichnung (7) für die praktisch einmalige Kennzeichnung des Substrats versehen ist, vorzugsweise einem eindimensionalen oder zweidimensionalen Barcode.

3. Substrat nach einem der vorhergehenden Ansprüche 1 und 2, wobei das Kennzeichnungsmuster jeder elektronischen Schaltung eine praktisch einmalige Kennzeichnung für die elektronische Schaltung bildet und wobei die praktisch einmalige Kennzeichnung die elektronische Schaltung in einer praktisch einmaligen Weise von mindestens 2²⁰, vorzugsweise 2²⁵, bevorzugter 2³⁰, anderen elektronischen Schaltungen mit den Kennzeichnungsmustern als praktisch einmalige Kennzeichnung unterscheiden kann.

4. Substrat nach einem der Ansprüche 1 bis 3, wobei die Vertiefungen für jede elektronische Schaltung entlang Rändern der Metallschicht bereitgestellt sind, vorzugsweise über eine Line pro Rand der Metallschicht, wobei die Linie pro Rand parallel zu den Rändern der Metallschicht liegt.

5. Substrat nach einem der Ansprüche 1 bis 4, wobei für jede elektronische Schaltung eine Vielzahl von Kennzeichnungspositionen entlang der Ränder der Metallschicht bereitgestellt ist und wobei das Kennzeichnungsmuster durch die Besetzung und/oder die Nicht-Besetzung der Kennzeichnungspositionen durch eine Vertiefung definiert ist, vorzugsweise wobei die aufeinanderfolgenden Kennzeichnungspositionen einen Abstand zwischen 200 µm und 2000 µm aufweisen.

6. Substrat nach einem der Ansprüche 1 bis 5, wobei mindestens eine der Kennzeichnungspositionen entlang mindestens eines der Ränder nicht von einer Vertiefung besetzt ist, vorzugsweise wobei sich diese mindestens eine nicht besetzte Kennzeichnungsposition zwischen Angabepositionen befindet, die von Vertiefungen des mindestens einen Randes besetzt sind, und wobei das Kennzeichnungsmuster infolge der Besetzung und/oder Nicht-Besetzung der Kennzeichnungspositionen mit den Vertiefungen eine binäre Darstellung aufweist.

7. Verwendung einer oder mehrerer Vertiefungen (6) als Kennzeichnungsmuster für eine elektronische Schaltung (2a, 2b, 2c), wobei die elektronische Schaltung eine im Wesentlichen ebene keramische Trägerschicht (5) und eine Metallschicht (4) an mindestens einer Seite, vorzugsweise an beiden Seiten der keramischen Trägerschicht umfasst, wobei mindestens eine Metallschicht mit den Vertiefungen in der Metallschicht entlang mindestens eines Randes der Metallschicht versehen ist und wobei die Vertiefungen dafür eingerichtet sind, Zugspannungen in der Metallschicht zumindest teilweise zu mindern, wobei das Kennzeichnungsmuster die elektronische Schaltung von mindestens anderen elektronischen Schaltungen unterscheidet, welche die gleiche keramische Trägerschicht (5) aufweisen, vorzugsweise wobei die elektronische Schaltung eine Schaltung auf einem Substrat mit direkt gebondetem Kupfer (DBC) zur Verwendung in Leistungselektronik betrifft.

8. Verfahren zum Anbringen von zugbelastungsverringernden Kennzeichnungsmustern auf einer Metallschicht (4) eines Substrats (1), wobei das Substrat eine Vielzahl von elektronischen Schaltungen (2a, 2b, 2c) umfasst, die folgenden Schritte umfassend:
a. Bereitstellen des Substrats (1), wobei die elektronischen Schaltungen (2a, 2b, 2c) eine Metallschicht (4) an mindestens einer Seite einer keramischen ebenen Trägerschicht (5) umfassen,
b. Anbringen einer oder mehrerer Vertiefungen (6) in der Metallschicht entlang mindestens eines Randes der Metallschicht, wobei die Vertiefungen dafür eingerichtet sind, Zugkräfte in der Metallschicht zumindest teilweise zu mindern,
wobei eine oder mehrere Vertiefungen in einem Kennzeichnungsmuster angebracht werden, wobei das Kennzeichnungsmuster die elektronische Schaltung mindestens in einer einmaligen Weise von den anderen elektronischen Schaltungen des Substrats unterscheidet,
c. Verbinden der elektronischen Schaltungen mit dem angebrachten Kennzeichnungsmuster in einem zentralen Server.

9. Verfahren für die verbesserte Produktion von Substraten (1) mit einer Vielzahl elektronischer Schaltungen, wobei die Schaltungen eine Metallschicht (4) an mindestens einer Seite der keramischen ebenen Trägerschicht (5) umfassen:
a. Produzieren des Substrats (1) in einer Produktionslinie mit einer oder mehreren Produktionsvorrichtungen, wobei das Substrat aus einem oder mehreren Rohmaterialien aus identifizierbaren Chargen des einen oder der mehreren Rohmaterialien produziert wird,
b. Anbringen eines zugbelastungsverringernden Kennzeichnungsmusters an einer Metallschicht des Substrats gemäß dem Verfahren des vorhergehenden Anspruchs 8,
c. zentrales Speichern von Informationen bezüglich der Produktionslinie und/oder der Produktionsvorrichtungen und/oder der identifizierbaren Charge der Rohmaterialien, die in dem Schritt des Produzierens des Substrats verwendet werden.

## Revendications

1. Substrat (1), de préférence pour une utilisation en électronique de puissance, comprenant :
a. une couche de support en céramique sensiblement plane (5) comprenant au moins deux circuits électroniques (2a, 2b, 2c) séparés qui sont connectés le long d'une ligne de rupture fragilisée (9) ;
b. une couche métallique (4) sur les circuits électroniques séparés au niveau d'au moins un côté, de préférence au niveau des deux côtés, de la couche de support en céramique, dans lequel la couche métallique des circuits électroniques séparés sont séparées le long des lignes de rupture ;
dans lequel une couche métallique d'au moins un, de préférence chacun, des circuits électroniques du substrat est dotée d'une ou plusieurs dépressions (6) dans la couche métallique le long d'au moins un bord de la couche métallique, dans lequel les dépressions sont adaptées pour réduire au moins partiellement les forces de traction dans la couche métallique ;
dans lequel les une ou plusieurs dépressions par circuit électronique forment un motif d'identification, dans lequel le motif d'identification distingue le circuit électronique d'au moins les autres circuits électroniques du substrat.

2. Substrat selon la revendication 1 précédente, dans lequel le substrat est doté d'une identification de substrat (7) pour l'identification pratiquement unique du substrat, de préférence un code à barres unidimensionnel ou bidimensionnel.

3. Substrat selon l'une quelconque des revendications 1 ou 2 précédentes, dans lequel le motif d'identification de chaque circuit électronique forme un identifiant pratiquement unique pour le circuit électronique et dans lequel l'identifiant pratiquement unique peut distinguer le circuit électronique d'une manière pratiquement unique d'au moins 2²⁰, de préférence 2²⁵, de manière davantage préférée 2³⁰, autres circuits électroniques avec les motifs d'identification en tant qu'identifiant pratiquement unique.

4. Substrat selon l'une quelconque des revendications 1 à 3, dans lequel les dépressions pour chaque circuit électronique sont fournies le long de bords de la couche métallique, de préférence sur une ligne par bord de la couche métallique dans lequel la ligne par bord est parallèle aux bords de la couche métallique.

5. Substrat selon l'une quelconque des revendications 1 à 4, dans lequel, pour chaque circuit électronique, une multitude de positions d'identification sont fournies le long des bords de la couche métallique, et dans lequel le motif d'identification est défini par l'occupation et/ou la non-occupation des positions d'identification par une dépression, de préférence dans lequel les positions d'identification successives ont un espacement entre 200 µm et 2 000 µm.

6. Substrat selon l'une quelconque des revendications 1 à 5 précédentes, dans lequel au moins l'une des positions d'identification le long d'au moins l'un des bords n'est pas occupée par une dépression, de préférence dans lequel cette au moins une position d'identification inoccupée est située entre des positions d'indication qui sont occupées par des dépressions de l'au moins un bord, et dans lequel le motif d'identification a une représentation binaire en résultat de l'occupation et/ou de la non-occupation des positions d'identification avec les dépressions.

7. Utilisation d'une ou plusieurs dépressions (6) en tant que motif d'identification pour un circuit électronique (2a, 2b, 2c), dans laquelle le circuit électronique comprend une couche de support en céramique sensiblement plane (5), et une couche métallique (4) au niveau d'au moins un côté, de préférence au niveau des deux côtés, de la couche de support en céramique, dans laquelle au moins une couche métallique est dotée des dépressions dans la couche métallique le long d'au moins un bord de la couche métallique, et dans laquelle les dépressions sont adaptées pour réduire au moins partiellement les contraintes de traction dans la couche métallique ; dans laquelle le motif d'identification distingue le circuit électronique d'au moins d'autres circuits électroniques comprenant la même couche de support en céramique (5), de préférence dans laquelle le circuit électronique concerne un circuit de substrat en céramique de cuivre directement lié (DBC) pour une utilisation en électronique de puissance.

8. Procédé d'application de motifs d'identification réduisant les contraintes de traction sur une couche métallique (4) d'un substrat (1), dans lequel le substrat comprend une multitude de circuits électroniques (2a, 2b, 2c), comprenant les étapes suivantes :
a. fourniture du substrat (1), dans lequel les circuits électroniques (2a, 2b, 2c) comprennent une couche métallique (4) au niveau d'au moins un côté d'une couche de support plane en céramique (5) ;
b. application d'une ou plusieurs dépressions (6) dans la couche métallique le long d'au moins un bord de la couche métallique, dans lequel les dépressions sont adaptées pour réduire au moins partiellement les forces de traction dans la couche métallique ;
dans lequel une ou plusieurs dépressions sont appliquées dans un motif d'identification, dans lequel le motif d'identification distingue le circuit électronique au moins d'une manière unique des autres circuits électroniques du substrat ;
c. couplage des circuits électroniques au motif d'identification appliqué dans un serveur central.

9. Procédé de production améliorée de substrats avec une multitude de circuits électroniques (1), dans lequel les circuits comprennent une couche métallique (4) au niveau d'au moins un côté d'une couche de support plane en céramique (5) :
a. production du substrat (1) le long d'une ligne de production avec un ou plusieurs dispositifs de production, dans lequel le substrat est produit avec une ou plusieurs matières premières à partir de lots identifiables des une ou plusieurs matières premières ;
b. application d'un motif d'identification réduisant les contraintes sur une couche métallique du substrat selon le procédé selon la revendication 8 précédente ;
c. stockage central d'informations relatives à la ligne de production et/ou aux dispositifs de production et/ou au lot identifiable des matières premières, qui sont utilisées dans l'étape de production du substrat.
